Europäisches Patentamt

European Patent Office

Office européen des brevets

(11) Publication number: **0 037 242**
**B1**

(12) **EUROPEAN PATENT SPECIFICATION**

(45) Date of publication of patent specification: **07.11.84**

(51) Int. Cl.³: **H 04 N 3/16,** G 01 S 7/06, H 03 K 4/62

(21) Application number: **81301280.4**

(22) Date of filing: **25.03.81**

(54) **Apparatus for raster scanning of a cathode ray beam.**

(30) Priority: **31.03.80 US 135372**

(43) Date of publication of application:
**07.10.81 Bulletin 81/40**

(45) Publication of the grant of the patent:
**07.11.84 Bulletin 84/45**

(84) Designated Contracting States:
**DE FR GB IT**

(56) References cited:
**DE-A-2 637 772**
**US-A-3 219 875**

**HEWLETT-PACKARD JOURNAL, Vol. 29, No. 8,
1978 J.C. KEITH et al. "System 45 Hardware
Design" pages 11 to 21**

(73) Proprietor: **SPERRY CORPORATION**
**1290, Avenue of the Americas**
**New York, N.Y. 10019 (US)**

(72) Inventor: **Spilsbury, Thomas William**
**2421 W. Kathleen Road**
**Phoenix Arizona 85023 (US)**

(74) Representative: **Singleton, Jeffrey et al**
**Eric Potter & Clarkson 5 Market Way Broad
Street**
**Reading Berkshire, RG1 2BN (GB)**

Courier Press, Leamington Spa, England.

## Description

This invention relates to apparatus for raster scanning of a cathode ray beam, and more particularly to horizontal deflection to linear deflection amplifier systems for use in raster scanned cathode ray tube displays requiring a selectively variable scan rate capability.

Prior horizontal raster scanning cathode ray beam deflection amplifier systems have used linear a.c. coupled correction of resonant scanning circuits for achieving improved sweep linearity, but it has been necessary to achieve display size or magnification control from a separate control element. For example, when a change in display size or in the scan rate was to be commanded, a predetermined bias voltage was inserted to generate the increased or decreased fly back switch voltage in an open loop fashion. The functions of the prior circuit normally interact so as not to remove certain undesired residual current levels that result in excess power loss and undesired heating of the deflection yoke and other circuit elements. Generally, it is also further desired to reduce the power required to drive such deflection systems, to improve sweep linearity, and to provide a fully compatible display size expand-compress function.

U.S. patent Specification No. 3,219,875 discloses waveform generating circuits suitable for the deflection coils of cathode ray tubes, which circuits comprise sweep generator means for providing a sweep waveform to cathode ray beam deflection coil means, fly back switch means coupled to the deflection coil means, current sampling means coupled to the deflection coil means, and circuit means responsive to current sampling means to produce an output signal representative of said current.

With respect to this known form of waveform generating circuit the present invention is characterised in that it further provides transformer means having an input responsive to signal generating means operable to generate a first pulsed wavetrain at a predetermined frequency, and an output coupled to both the sweep generator means and the fly back switch means, differential means responsive to the sweep signal generator means and to the current sampling means to provide an error signal, and further circuit means responsive to the error signal for further controlling the fly back switch means for varying the deflection coil current in a manner to reduce the error signal to zero.

In its preferred form the present invention provides an improved linear cathode ray beam deflection amplifier system which is self-adaptive to variable scan rate and display size. It provides sweep wave linearity through the use of feedback control and also, through the same feedback control, is self-adaptive with respect to commanded changed in raster scan rate or display size. It supplies an expand-contract or zoom function wherein the horizontal and vertical scans may be cooperatively lengthened or diminished by changing the fly back switching circuit voltage to drive the required increased or decreased current through the deflection coil. The display deflection amplifier system provides automatic response to line rate change or to expand-contract commands, while improving the inherent low power consumption advantages of the prior resonant scan technique by d.c. coupling the sweep wave of the correction amplifier to the resonant scan circuit to produce an error signal that is fed forward to adjust the fly back pulse amplitude in a manner to reduce that error to zero and thereby also to provide the desired linear deflection yoke current.

Apparatus according to the invention will now be described, by way of example, with reference to the accompanying drawings, in which:—

Figure 1 is a schematic wiring diagram of a typical cathode ray beam deflection system incorporating the apparatus, and

Figure 2 illustrates significant waveforms found at indicated locations in the circuit of Figure 1.

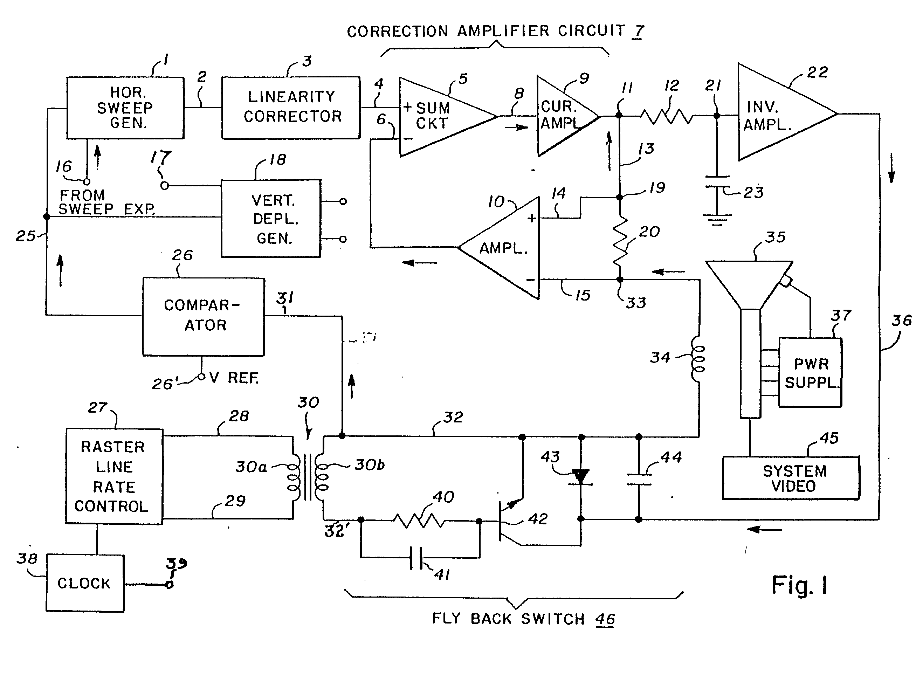

Figure 1 illustrates a horizontal magnetic electron beam deflection system which provides a capability for operating at a variable horizontal or other scan rate, such as selectively at scan rates of 525 or 875 lines. Such selectivity is needed, for example, in certain airborne indicators wherein a presentation having a first resolution is appropriate for one type of display and a second and higher resolution presentation is needed for a second type of display.

Operation of the system is controlled by the conventional pulse train synchroniser or raster line rate control 27 whose repetition rate or frequency is controlled conventionally by the system clock 38; the raster line frequency may be changed by a discrete command signal applied at a terminal 39. The synchronising train from the control 27 is coupled via leads 28, 29 to the primary winding 30a of a pulse transformer 30 whose output or secondary winding 30b is coupled via leads 32, 32' into a resistor 40 and a capacitor 41. One current path from the secondary windings 30b leads into the conventional fly back switching circuit 46, as will be further discussed.

A second current path is taken from the lead 32 to one input 31 of a conventional amplitude comparator circuit 26 to which is coupled at a second input 26' a stable voltage reference. The consequent output error voltage pulses are coupled as trigger pulses by a lead 25 to a conventional horizontal sweep voltage generator 1 having a sweep expansion command discrete input terminal 16, and two conventional controlling inputs. Thus, pulses on the lead 25 are delayed slightly with respect to those on the lead 28, ensuring the proper phase relation between the sweep wave form on a lead 2 and the fly back pulse on the lead 32. The expansion command discrete input, coupled at the terminal 16, permits conventional control of the expansion of the horizontal sweep. A conventional vertical blanking pulse coupled at a terminal 17 of a vertical deflection generator 18 conventionally enables the vertical sweep wave. The linear slope saw tooth sweep output current of the generator 1 is coupled by the lead 2 to a shaping correction circuit 3 and thence, via a lead 4, to one input of a sum circuit 5 in the polarity indicated, along with a second input, yet to be discussed and found on a lead 6. It is convenient to refer to the sum circuit 5 and a current amplifier 9 as a correction amplifier circuit 7.

The summation output on a lead 8 is coupled to the conventional current amplifier 9, whose output is coupled through a junction 11, a resistor 12, and a junction 21 (which is coupled by a capacitor 23 to ground) to an inverting amplifier 22, and by lead 36 into one of the terminals of the conventional fly back switching circuit 46. A companion terminal of the circuit 46 and the lead 32 is coupled through a conventional cathode ray deflection coil 34 associated with a cathode ray tube 35 and through resistor 20 and lead 13 to the terminal 11 at the input of the inverter amplifier 22. A voltage is derived across the terminals 19, 33 of the resistor 20 and is applied to respective input leads 14, 15 of a sensing amplifier 10 to provide an output current on the lead 6 proportional to this voltage, which current, in turn, is connected to the second input of the sum circuit 5.

It will be understood that the cathode ray tube 35 is associated with the usual power supply 37, and that video signals such as radar echo signals or other such information signals may be derived for it in conventional system video circuits represented schematically at 45.

The conventional fly back switching circuit 46 includes the lead 32 directly connecting the output of the transformer secondary winding 30$b$ to one end of the deflection coil 34. The opposite end of the secondary winding 30$b$ is coupled by the lead 32' through the shunt connected resistor 40 and speed-up capacitor 41 to the base of a fly back transistor 42, the emitter of which is connected to the lead 32. The collector electrode of the transistor 42 is coupled to the lead 36 and through a fly back diode 43 to the lead 32. A fly back capacitor 44 is shunted across the diode 43.

In considering the operation of the system, it is convenient to note that the required voltage across the deflection coil 34 is represented by the basic relation $L\,di/dt + iR$, and that the last term is the conventional voltage drop across the resistor 20 and the resistance of the coil 34. The $L\,di/dt$ term includes two components:

1) a small amplitude, high frequency a.c. component $di'/dt$ normally held close to zero by the current sample fed back through the amplifier 10 to the input of the sum circuit 5, and

2) a component $di''/dt$ produced by changes in current flowing through the coil 34 caused by:

a) size change commands injected by a size change discrete pulse at the terminal 16 from a conventional source (increasing or decreasing the sweep ramp amplitude and detected through the sum circuit 5,) or

b) raster line frequency change command discrete exercised through the raster line rate control 27 (increasing or decreasing the fly back drive frequency and detected through the horizontal drive comparator 26 and the sum circuit 5).

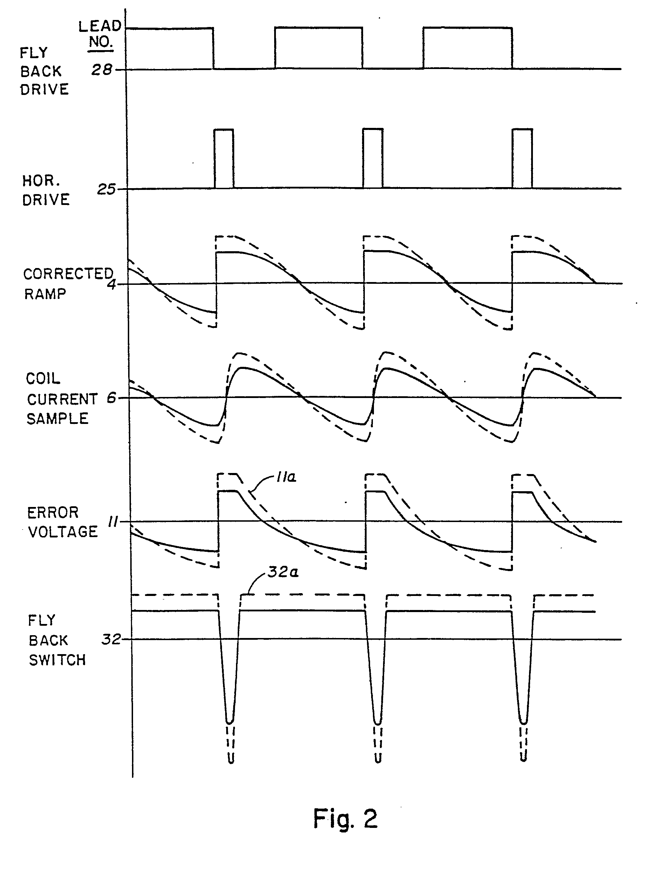

Referring to Figures 1 and 2, operation of the system will now be considered; the raster line rate control 27 supplies a relatively square wave pulse train having a frequency of, say 15,750 Hz, for example, through the transformer 30 to the conventional fly back switch circuit 46, which causes generation in that low power resonant scan circuit of a deflection driving current for application to the coil 34. A horizontal deflection drive pulse train with pulses in phase with the fly back switching pulse is generated by the amplitude comparator 26 by comparison with the reference voltage at the input 26'. That drive pulse train appears on the lead 25, the pulses having relatively short duration with respect to the pulses on the lead 28. The pulse train on the lead 25 is used to trigger and to synchronise each sweep of a repetitive sweep wave train formed by the conventional synchronised horizontal sweep generator 1.

The fly back circuit operates in a generally conventional manner; when the fly back transistor 42 is made conductive by a positive-going pulse on its base (coupled through the transformer 30, the resistor 40, and the speed-up capacitor 41), current in the coil 34 begins to increase linearly. When the transistor 42 is turned off by a negative-going pulse coupled through the transformer 30, coil current flows through the fly back capacitor 44. This event produces a sinusoidal resonant fly back between the coil inductance and the capacitance of the capacitor 44. After one half period of this resonant current, the diode 43 becomes conductive and the current decays linearly to zero, at which time the transistor 42 is made conductive again.

The sawtooth output of the generator 1 is shaped in the linearity correction circuit 3 to compensate in a conventional way for pincushion and other such tube geometry effects and to form a conventional cathode ray beam sweep current in the lead 4, as seen in Figure 2. The signal on the lead 4 is applied to the sum circuit 5 where it is, in effect, compared with the actual substantially linear deflection coil current sensed by the coil current sensing amplifier 10. The effective error signal at the junction 11 is an alternating voltage including undesired components produced by the iR losses in the circuit path and by switching losses such as those in the fly back switching circuit 46, together with the desired deflection coil current error signal and the actual current through the lead 13. It will be recognised that, as a matter of convenience, the variations in slopes of the wave forms in Figure 2 are exaggerated.

It is seen that the iR and fly back switch circuit losses and the small amplitude a.c. errors are corrected by the conventional correction amplifier circuit 7 so that only large amplitude, low frequency a.c. signals at the junction 11 are primarily the sweep error $di''/dt$. That error is coupled through the inverter amplifier 22 and is fed back via the lead 36 to the resonant scan fly back circuit 46, thereby to adjust the current through the deflection coil 34 so as to reduce the error at the junction 11 nearly to zero, thereby precisely providing the desired cathode ray beam deflection current.

Magnification of the central region of the cathode ray tube display is accomplished by lengthening the horizontal scan, the vertical scan length following automatically by virtue of the control of vertical deflection generator 18 by the pulsed wave train on the lead 25. When a sweep expand command discrete signal is supplied to the sweep generator 1 at the terminal 16, the result is to increase the amplitude of the sawtooth wave output. It is to be observed that the expand (compress) command is accomplished at the sweep generator 1 and therefore before exercise of linearity correction in the circuit 3, so that the operation of the linearity corrector 3 is the same for all sweep wave amplitudes.

At the instant that the expand command is instituted, the fly back switch voltage has not yet changed and the deflection coil current and the current sense feed back signal remain essentially unchanged. Accordingly, a large error signal then appears at the junction 11 (the dotted curve 11a in Figure 2) corresponding to the aforementioned $di''/dt$ term. This component is coupled through the low pass filter 12, 23 to the inverter amplifier 22 to provide a corresponding increase in the voltage on the lead 36. Voltage increases coupled to the fly back switching circuit 47 causes the deflection coil current 32a (Figure 2) to change in an amount such as to increase the output of the current sensing amplifier 10 until it has the same amplitude as the expanded sweep input of the sum circuit 5, thus reducing the error at the junction 11 to substantially zero. It will be understood that removal of the expand discrete signal applied at the terminal 16 will cause the described operation to reverse.

If it is desired further to change the resolution of the display by increasing the number of horizontal lines in the raster, for example, from 525 to 875 lines, such may be accomplished by supplying on the fly back circuit input lead 28 a pulse train having a pulse repetition rate of, say, 26,250 Hz. This provides 875 horizontal lines at a frame-to-field ratio of 30/60. The increase in pulse repetition frequency requires a corresponding increase in $di/dt$; because the increase is also applied to the sweep generator 1 through the comparator 26, the feed back operation of the deflection system adapts the voltage on the lead 36 as previously described when size change is commanded.

Accordingly, it is seen that the described system overcomes the problems of the prior art by providing an improved cathode ray display deflection amplifier having a selectable variable scan rate capacity, providing sweep wave linearity through the use of feedback control which also cooperates in a self-adaptive closed-loop manner with respect to commanded changes in raster scan rate or display size. The novel deflection system reduces power consumption and has good sweep linearity. Once calibrated, the deflection system needs only the automatically provided changes in fly back pulse amplitude to provide the proper current to the beam deflection yoke.

## Claims

1. Apparatus for raster scanning of a cathode ray beam of a display device (35), the apparatus comprising sweep generator means (1, 3) for providing a sweep waveform to cathode ray beam deflection coil means (34), fly back switch means (46) coupled to the deflection coil means, current sampling means (20) coupled to the deflection coil means, and circuit means (10) responsive to current sampling means to produce an output signal representative of said current, characterised in that the apparatus further comprises transformer means (30) having an input responsive to signal generating means (27, 38) operable to generate a first pulsed wavetrain at a predetermined frequency, and an output coupled to both the sweep generator means (1) and the fly back switch means (46), differential means (5) responsive to the sweep signal generator means (1) and to the current sampling means (20) to provide an error signal, and further circuit means (12, 22, 23) responsive to the error signal for further controlling the fly back switch means (46) for varying the deflection coil current in a manner to reduce the error signal to zero.

2. Apparatus according to claim 1, characterised in that it further comprises further circuit means (26) coupled to the signal generator means (27, 38) and operable to generate a second pulsed wavetrain according to said predetermined frequency in the form of delayed trigger pulses which are applied to the sweep generator (1) whereby the latter generates a substantially linear sweep voltage wavetrain having a variable amplitude control.

3. Apparatus according to claim 1 or 2, characterised in that the further circuit means comprises a low pass filter (12, 23) coupled to the output of the differential means (5), and inverter amplifier means coupled to the output of the low pass filter, the output of the inverter amplifier means being coupled to the fly back switch means (46).

4. Apparatus according to any of the preceding claims, characterised in that the differential means comprises summation means (5).

5. Apparatus according to any of the preceding claims, characterised in that the signal generator means comprises comparator means (26) utilising a voltage reference and the first pulse wave train for producing trigger pulses initiated at the end of each pulse of the first pulse wave train.

6. Apparatus according to any of the preceding claims, characterised in that the circuit means comprises amplifier means (10) coupled across the current sampling means (20), and resistor means coupled between the amplifier means output and the second input means.

7. Apparatus according to any of the preceding claims, characterised in that it further includes wave shaping means interposed between the differential means (5) and circuit means (12, 23).

8. Apparatus according to any of the preceding claims, characterised in that the fly back switch means (46) includes, first capacitor means (41), and resistor means (40) coupled in parallel, transistor means (42) having its base coupled to the second resistor means (40) and the first capacitor means (41), and its emitter and collector coupled in parallel with both diode means (43) and second capacitor means (44), the transistor means (42), diode means (43) and the second capacitor means (44), being connected between the output of the differential means (5) and one end of the coil deflection means (34).

**Revendications**

1. Appareil de balayage par trame du faisceau d'un tube à rayons cathodiques d'un dispositif d'affichage (35), l'appareil comprenant un générateur de balayage (1, 3) destiné à transmettre une forme d'onde de balayage à un dispositif à bobine (34) de déviation du faisceau de rayons, un dispositif de commutation de retour de spot (46) relié au dispositif à bobine, un dispositif (20) d'échantillonnage de courant relié au dispositif à bobine de déviation, et un circuit (10) commandé par le dispositif d'échantillonnage de courant et destiné à former un signal de sortie représentatif de ce courant, caractérisé en ce que l'appareil comporte en outre un transformateur (30) ayant une entrée sensible au dispositif générateur de signaux (27, 38) et destiné à créer un premier train d'ondes pulsées à une fréquence prédéterminée, et une sortie reliée à la fois au générateur de balayage (1) et au dispositif de commutation de retour de spot (46), un dispositif différentiel (5) commandé par le générateur (1) de signaux de balayage et par le dispositif d'échantillonnage de courant (20) et destiné à transmettre un signal d'erreur, et un circuit supplémentaire (12, 22, 23) commandé par le signal d'erreur et destiné à commander en outre le dispositif de commutation de retour de spot (46) afin qu'il fasse varier le courant du dispositif à bobine de déviation d'une manière qui réduit à zéro le signal d'erreur.

2. Appareil selon la revendication 1, caractérisé en ce qu'il comprend en outre un circuit supplémentaire (26) relié au générateur de signaux (27, 38) et destiné à créer un second train d'ondes pulsées d'après la fréquence prédéterminée sous forme d'impulsions retardées de déclenchement qui sont appliquées au générateur de balayage (1) si bien que ce dernier crée un train d'ondes sous forme d'une tension sensiblement linéaire de balayage ayant un réglage d'amplitude variable.

3. Appareil selon l'une des revendications 1 et 2, caractérisé en ce que le circuit supplémentaire comporte un filtre passe-bas (12, 23) relié à la sortie du dispositif différentiel (5), et un amplificateur d'inversion relié à la sortie du filtre passe-bas, la sortie de l'amplificateur d'inversion étant reliée au dispositif de commutation de retour de spot (46).

4. Appareil selon l'une quelconque des revendications précédentes, caractérisé en ce que le dispositif différentiel comprend un dispositif de sommation (5).

5. Appareil selon l'une quelconque des revendications précédentes, caractérisé en ce que le générateur de signaux comporte un comparateur (26) utilisant une référence de tension et le premier train d'ondes pulsées pour la formation d'impulsions de déclenchement qui commencent à la fin de chaque impulsion du premier train d'ondes pulsées.

6. Appareil selon l'une quelconque des revendications précédentes, caractérisé en ce que le circuit comprend un amplificateur (10) couplé aux bornes du dispositif d'échantillonnage de courant (20), et un dispositif résistif monté entre la sortie de l'amplicateur et la seconde entrée.

7. Appareil selon l'une quelconque des revendications précédentes, caractérisé en ce qu'il comprend en outre un dispositif conformateur placé entre le dispositif différentiel (5) et ledit circuit (12, 23).

8. Appareil selon l'une quelconque des revendications précédentes, caractérisé en ce que le dispositif de commutation de retour de spot (46) comprend un premier dispositif capacitif (41) et un dispositif résistif (40) montés en parallèle, un dispositif à transistor (42) dont la base est reliée au second dispositif résistif (40) et au premier dispositif capacitif (41), et dont l'émetteur et le collecteur sont reliés en parallèle à la fois à un dispositif à diode (43) et à un second dispositif capacitif (44), le dispositif à transistor (42), le dispositif à diode (43) et le second dispositif capacitif (44) étant montés entre la sortie du dispositif différentiel (5) et une première extrémité du dispositif à bobine de déviation (34).

## Patentansprüche

1. Gerät zur Rasterabtastung mittels eines Kathodenstrahls einer Anzeigeeinrichtung (35), mit Ablenkgeneratoreinrichtungen (1, 3) zur Lieferung einer Ablenkschwingungsform an Kathodenstrahl-Ablenkspuleneinrichtungen (34), mit mit den Ablenkspuleneinruchtungen gekoppelten Rücklaufschaltereinrichtungen (46), mit Stromabtasteinrichtungen (20), die mit den Ablenkspuleneinrichtungen gekoppelt sind, und mit auf die Stromabtasteinrichtungen ansprechenden Einrichtungen (10) zur Erzeugung eines diesen Strom darstellenden Ausgangssignals, dadurch gekennzeichnet, daß das Gerät weiterhin Transformatoreinrichtungen (30) mit einem Eingang, der auf Signalgeneratoreinrichtungen (37, 38) zur Erzeugung einer ersten impulsförmigen Schwingungsfolge mit einer vorgegebenen Frequenz anspricht und mit einem Ausgang, der sowohl mit den Ablenkgeneratoreinrichtungen (1) als auch den Rücklaufschaltereinrichtungen (46) gekoppelt ist, Differentialeinrichtungen (5), die auf die Ablenksignalgeneratoreinrichtungen (1) und die Stromabtasteinrichtungen (20) ansprechen, um ein Fehlersignal zu erzeugen, und weitere Schaltungseinrichtungen (12, 22, 23) umfaßt, die auf das Fehlersignal zur weiteren Steuerung der Rücklaufschaltereinrichtungen (46) zur Änderung des Ablenkspulenstromes in einer derartigen Weise ansprechen, daß das Fehlersignal auf Null verringert wird.

2. Gerät nach Anspruch 1, dadurch gekennzeichnet, daß es weiterhin mit den Signalgeneratoreinrichtungen (27, 38) gekoppelte Schaltungseinrichtungen (26) zur Erzeugung einer zweiten impulsförmigen Schwingungsfolge entsprechend der vorgegebenen Frequenz in Form von verzögerten Trägerimpulsen umfaßt, die dem Ablenkgenerator (1) zugeführt werden, so daß dieser eine im wesentlichen lineare Ablenkspannungs-Schwingungsfolge mit einer änderbaren Amplitudensteuerung erzeugt.

3. Gerät nach Anspruch 1 oder 2, dadurch gekennzeichnet, daß die weiteren Schaltungseinrichtungen ein mit dem Ausgang der Differentialeinrichtungen (5) gekoppeltes Tiefpaß-Filter (12, 23) und Invertierverstärkereinrichtungen umfassen, die mit dem Ausgang des Tiefpaß-Filters gekoppelt sind, wobei der Ausgang der Inverterverstärkereinrichtungen mit Rücklaufschaltereinrichtungen (46) gekoppelt ist.

4. Gerät nach einem der vorhergehenden Ansprüche, dadurch gekennzeichnet, daß die Differentialeinrichtungen Summeriereinrichtungen (5) umfassen.

5. Gerät nach einem der vorhergehenden Ansprüche, dadurch gekennzeichnet, daß die Signalgeneratoreinrichtungen Komparator-Einrichtungen (26) umfassen, die eine Bezugsspannung und die erste impulsförmige Schwingungsfolge verwenden, um Trägerimpulse zu erzeugen, die am Ende jedes Impulses der ersten impulsförmigen Schwingungsfolge eingeleitet werden.

6. Gerät nach einem der vorhergehenden Ansprüche, dadurch gekennzeichnet, daß die Schaltungseinrichtungen längs der Stromabtasteinrichtungen (20) angeschaltete Verstärkereinrichtungen (10) und zwischen dem Ausgang der Verstärkereinrichtungen und die zweiten Eingangseinrichtungen eingeschaltete Widerstandselemente umfassen.

7. Gerät nach einem der vorhergehenden Ansprüche, dadurch gekennzeichnet, daß es weiterhin Schwingungsformereinrichtungen einschließt, die zwischen den Differentialeinrichtungen (5) und den Schaltungseinrichtungen (12, 13) eingefügt sind.

8. Gerät nach einem der vorhergehenden Ansprüche, dadurch gekennzeichnet, daß die Rücklaufschaltereinrichtungen (46) ein erstes Kondensatorelement (41) und ein hierzu parallel geschaltetes Widerstandselement (40) und ein Transistorelement (42) einschließen, dessen Basis mit dem zweiten Widerstandselement (40) und dem ersten Kondensatorelement (41) gekoppelt ist und dessen Emitter und Kollektor parallel sowohl mit einem Diodenelement (43) als auch mit einem zweiten Kondensatorelement (44) gekoppelt sind, und daß das Transistorelement (42), das Diodenelement (43) und das zweite Kondensatorelement (44) zwischen den Ausgang der Differentialeinrichtungen (5) und ein Ende der Ablenkspuleneinrichtungen (34) geschaltet sind.

Fig. I

Fig. 2

2